# EUROPEAN PATENT APPLICATION

(11) **EP 1 860 486 A2**
(43) Date of publication of application: **28.11.2007**
(21) Application number: 07009756.3
(22) Date of filing: 16.05.2007
(51) Int. Cl.: G02F 1/13

(54) **Printed circuit board for flat panel display, flat panel display having the same, and method thereof**

(30) Priority: 26.05.2006 KR 20060047650
(71) Applicant: Samsung Electronics Co., Ltd., Yeongtong-gu Suwon-city, Gyeonggi-do 442-742 (KR)
(72) Inventor: Yun, Su Young, Cheonan-Si Chungcheongnam-Do, 330-735 (KR)
(74) Representative: Weitzel, Wolfgang

(57) **Abstract**

The present invention relates to a printed circuit board ("PCB") for a flat panel display, which is formed with a coupling member (255) made of a conductive material to be grounded with a container (900) of the flat panel display, a flat panel display having the PCB, and a method of coupling the PCB within the flat panel display. The PCB includes a base plate (251) with a circuit pattern printed thereon to mount a plurality of circuit parts driving the flat panel display, and a coupling member (255) formed on the base plate in the form of a protrusion and made of a conductive material.

## Description

### BACKGROUND OF THE INVENTION

### 1. Field of the Invention

The present invention relates to a printed circuit board ("PCB") for a flat panel display, a flat panel display having the PCB, and a method thereof. More specifically, the present invention relates to a PCB for a flat panel display including a coupling structure, a flat panel display having the PCB, and a method of coupling the PCB with respect to the flat panel display.

### 2. Description of the Related Art

In general, a flat panel display such as a liquid crystal display ("LCD") is advantageous over a conventional cathode ray tube ("CRT") in that it is smaller, more lightweight, and has a larger screen. Thus, the development of the flat panel display has been vigorously made. The flat panel display can be used in various applications such as in a laptop computer, in a monitor for a desktop computer, for a large-sized display, etc. An LCD is used to adjust an amount of light transmitted in accordance with image signals applied to a number of control switches arrayed in a matrix form and then displays a desired image on an LCD panel. The LCD includes an LCD panel on which images are displayed directly, a printed circuit board ("PCB") mounted with a driving unit for transferring an external signal to the LCD panel and a variety of circuit parts, a backlight unit for irradiating light onto the LCD panel, a mold frame for receiving the LCD panel and the backlight unit, and a container for housing the aforementioned components. At this time, the PCB is either arranged on an upper surface of the mold frame or attached to a sidewall thereof.

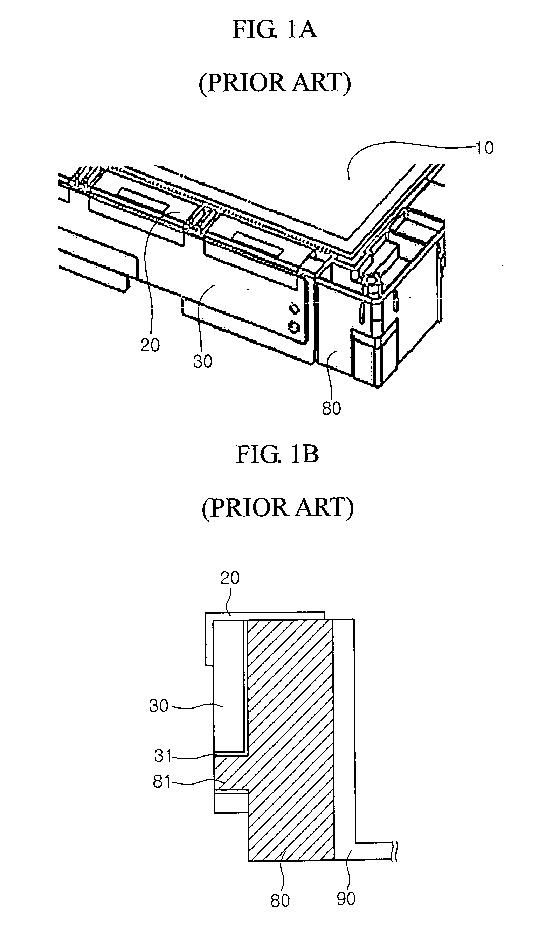

Figs. 1A and 1B are perspective and sectional views respectively showing a state where a PCB of a conventional LCD is coupled to a mold frame. Referring to Figs. 1A and 1B, a protrusion 81 having a predetermined shape is formed on a sidewall of a mold frame 80 and a hole 31 having a shape and size corresponding to the protrusion 81 is formed in a PCB 30 connected to an LCD panel 10 via a flexible PCB 20. The protrusion 81 of the mold frame 80 is tight fitted into the hole 31 of the PCB 30 such that the PCB 30 can be fixed to the sidewall of the mold frame 80.

However, if the PCB 30 is fixed to the sidewall of the mold frame 80 in the same way as mentioned above, they may be incompletely or loosely coupled with each other due to a variation in the shape and size of the protrusion 81 according to an extrusion condition of the mold frame 80 as well as a variation in the size of the hole 31 formed in the PCB 30.

Further, in order to shield the electromagnetic interference between circuit parts mounted to the PCB 30, a gasket should be additionally installed such that the PCB 30 can be grounded with a lower or upper container 90.

### BRIEF SUMMARY OF THE INVENTION

The present invention solves the aforementioned problems in the prior art, and accordingly, exemplary embodiments of the present invention provide a printed circuit board ("PCB") for a flat panel display, which can be easily coupled with a mold frame and a container and is formed with a coupling member for allowing the PCB to be grounded with the container, and provides a flat panel display having the PCB and a method thereof.

According to exemplary embodiments of the present invention, there is provided a PCB for a flat panel display, including a base plate with a circuit pattern printed thereon to mount a plurality of circuit parts driving the flat panel display, and a coupling member formed on the base plate, the coupling member formed in a form of a protrusion and made of a conductive material.

The coupling member may include a body portion, a fixing portion formed at a first end of the body portion and fixed to the base plate, and a head portion formed at a second end of the body portion and coupled to a container of the flat panel display.

Preferably, the fixing portion extends in a direction perpendicular to the body portion.

The fixing portion may be arranged on one surface of the base plate and fixed to the base plate by solder. Further, a coupling hole may be formed in the base plate, the body portion may be positioned in the coupling hole, and the fixing portion of the coupling member may be arranged on a surface of the base plate and fixed to the base plate by solder.

Alternatively, a coupling hole may be formed in the base plate, a groove may be formed in an inner sidewall of the coupling hole, and the fixing portion of the coupling member is inserted and fixed in the groove.

Preferably, the head portion includes a first end having a width greater than a width of the body portion, and a second end tapering from the first end. Further, a groove may be formed in a central region of the head portion such that the head portion is separated into two parts spaced apart from each other by a distance.

The coupling member may further include a catching protrusion protruding outwardly from the body portion. Preferably, the body portion, the fixing portion, and the head portion of the coupling member are integrally formed with one another.

At least two coupling members may be formed at corner regions of the base plate. Further, the coupling member may be made of copper or alloy thereof.

According to other exemplary embodiments of the present invention, a flat panel display includes a flat display panel displaying an image thereon, a PCB mounted with a plurality of circuit parts driving the flat display panel, a frame formed with a receiving space therein, and a container coupled with the frame, wherein the PCB includes a base plate with a circuit pattern printed thereon to mount the plurality of circuit parts thereon, and a coupling member formed on the base plate, the coupling member formed in a form of a protrusion and made of a conductive material, and the coupling member of the PCB coupled to the container.

According to other exemplary embodiments of the present invention, a method of coupling a PCB within a flat display includes affixing a conductive coupling member to a base plate of the PCB, passing the coupling member through a coupling hole formed in a frame of the flat panel display, and passing the coupling member through a coupling hole formed in a container of the flat panel display. The method may further include forming a ground structure between the PCB and the container by contacting the coupling member to the container.

### BRIEF DESCRIPTION OF THE DRAWINGS

The above and other features and advantages of the present invention will become apparent from the following descriptions of exemplary embodiments given in conjunction with the accompanying drawings, in which:
Figs. 1A and 1B are perspective and sectional views respectively illustrating a state where a conventional printed circuit board ("PCB") of a liquid crystal display ("LCD") is coupled to a mold frame;
Fig. 2 is an exploded perspective view showing an exemplary LCD including an exemplary PCB according to an exemplary embodiment the present invention;
Fig. 3 is a schematic perspective view of an exemplary PCB according to a first exemplary embodiment of the present invention;
Figs. 4A and 4B are perspective and sectional views respectively illustrating a state where the exemplary PCB according to the first exemplary embodiment of the present invention is coupled to an exemplary mold frame and an exemplary lower container;
Fig. 5 is a schematic perspective view of an exemplary PCB according to a second exemplary embodiment of the present invention;
Figs. 6A and 6B are perspective and sectional views respectively illustrating a state where the exemplary PCB according to the second exemplary embodiment of the present invention is coupled to an exemplary mold frame and an exemplary lower container;
Figs. 7A and 7B are perspective and sectional views respectively illustrating a state where the exemplary PCB according to a third exemplary embodiment of the present invention is coupled to an exemplary mold frame and an exemplary lower container;
Figs. 8A and 8B are a perspective view of an exemplary PCB according to a fourth exemplary embodiment of the present invention and a sectional view illustrating a state where the exemplary PCB is coupled to an exemplary mold frame and an exemplary lower container, respectively;
Figs. 9A and 9B are a perspective view of an exemplary PCB according to a fifth exemplary embodiment of the present invention and a sectional view illustrating a state where the exemplary PCB is coupled to an exemplary mold frame and an exemplary lower container, respectively; and
Fig. 10 is an exploded perspective view showing another exemplary LCD including the exemplary PCB according to an exemplary embodiment of the present invention.

### DETAILED DESCRIPTION OF THE INVENTION

The invention will now be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present there between. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, preferred embodiments of the present invention will be described in more detail with reference to the accompanying drawings.

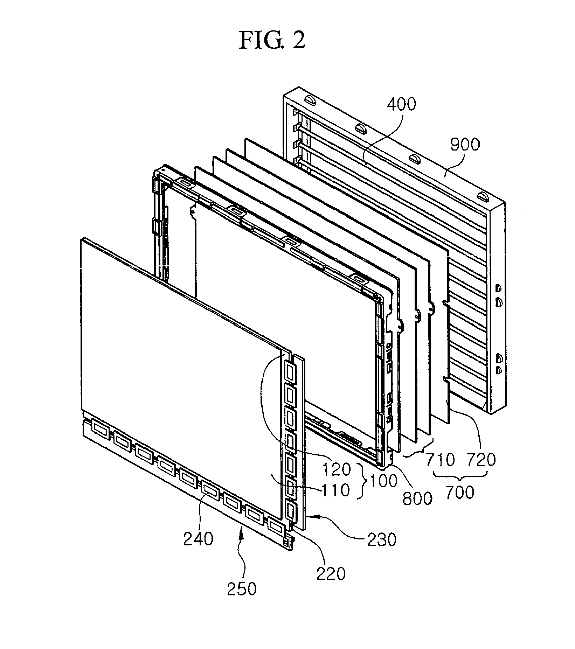

Fig. 2 is an exploded perspective view showing an exemplary liquid crystal display ("LCD") including a printed circuit board ("PCB") according to an exemplary embodiment of the present invention.

Referring to Fig. 2, the LCD includes an LCD panel 100, a driving circuit unit 220 to 250, an upper container (not shown), a plurality of optical sheets 700, a lamp unit 400, a mold frame 800, and a lower container 900.

The LCD panel 100 includes a color filter substrate 110 and a thin film transistor ("TFT") substrate 120. The color filter substrate 110 and the TFT substrate 120 are arranged to face each other, and a liquid crystal layer (not shown) is injected between the substrates. The color filter substrate 110 is a substrate that may be formed through a thin film forming process with a red, green, and blue ("RGB") color filter that serves as a color pixel from which a predetermined color is produced while light passes through the pixel. A common electrode made of a transparent conductor such as indium tin oxide ("ITO") or indium zinc oxide ("IZO") is coated on the front surface of the color filter substrate facing the TFT substrate 120.

The TFT substrate 120 includes a transparent substrate, such as formed from glass or plastic, on which TFTs are formed in a matrix pattern. Data lines are connected to source terminals of the TFTs, while gate lines are connected to gate terminals thereof. Further, pixel electrodes each of which includes a transparent electrode made of a transparent conductive material is connected to drain terminals of the TFTs. If electric signals are input to the data and gate lines, the respective TFTs are turned on or off such that the electrical signals required in the formation of pixels can be applied to the drain terminals. If electric power is applied to the gate and source terminals of the TFT substrate to turn on a TFT, an electric field is created between the pixel electrodes and the common electrode of the color filter substrate. As a result, the liquid crystal injected between the TFT substrate and the color filter substrate changes its arrangement, and thus, the light transmittance is also changed in accordance with the changed alignment, so that desired images can be obtained.

The driving circuit unit is connected to the LCD panel 100. The driving circuit unit includes a gate-side PCB 230 equipped with a control integrated circuit ("IC") to apply a predetermined gate signal to the gate lines of the TFT substrate 120, a data-side PCB 250 equipped with a control IC to apply a predetermined data signal to the data lines of the TFT substrate 120, a gate-side flexible PCB 220 for connecting the TFT substrate 120 and the gate-side PCB 230, and a data-side flexible PCB 240 for connecting the TFT substrate 120 and the data-side PCB 250.

The gate-side and data-side PCBs 230 and 250 are connected to the gate-side and data-side flexible PCBs 220 and 240, respectively, to apply a gate driving signal and an external image signal. Alternatively, the gate-side and data-side PCBs 230 and 250 may be integrated into a single PCB. In addition, since each of the gate-side and data-side flexible PCBs 220 and 240 is mounted with a driving IC (not shown), digital power and RGB signals generated from the gate-side and data-side PCBs 230 and 250 can be transmitted to the LCD panel 110. Although the tape-automated bonding ("TAB") mounting method is described, by way of example, in these exemplary embodiments of the present invention, the present invention may be applied to the chip on glass ("COG") mounting method in which a driving IC is not mounted to the flexible PCBs 220 and 240 but to the TFT substrate.

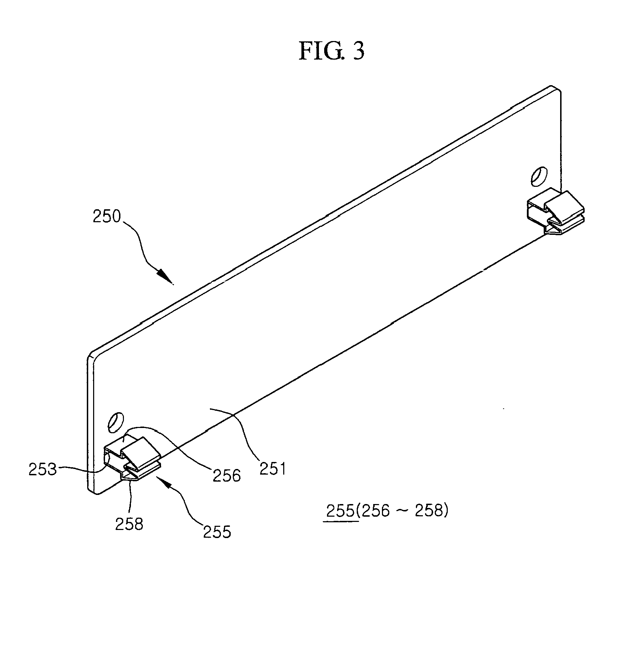

In addition, as further shown in Fig. 3, the data-side PCB 250 is arranged on a sidewall of the mold frame 800 and coupled with the lower container 900. In order to implement such a coupling structure, a coupling member 255 made of a conductive material in the form of a protrusion is formed on both side edges of the data-side PCB 250 and is coupled to a coupling hole formed in the mold frame 800 and a coupling hole formed in the lower container 900. Thus, the data-side PCB 250 is fixed to one sidewall of the mold frame 800 and the lower container 900 is also coupled such that a ground structure is formed. As a result, contrary to the prior art, the PCB 250 and the mold frame 800 are easily coupled with each other, and the PCB 250 is coupled to the lower container 900 by means of the coupling member 255. Thus, the PCB 250 is grounded to the lower container 900. In this connection, a ground structure between the PCB 250 and the lower container 900 can be formed without using any additional components, and electromagnetic interference can be shielded. At this time, in order to improve the shielding effect of the electromagnetic interference, the coupling member 255 is preferably made of a material with excellent electric conductivity, e.g. copper or its alloy such as bronze and phosphor bronze.

Although it is described in this exemplary embodiment and the following exemplary embodiments that the coupling member 255 is formed on the data-side PCB 250, such description is merely for convenience of explanation and the scope of the present invention is not limited thereto. For example, one or more coupling members may be formed on the gate-side PCB 230, and one or more coupling members may be formed on both PCBs 230, 250. Meanwhile, a coupling structure of the coupling member 255 will be further described below.

The lamp unit 400 includes a plurality of lamps arranged in parallel, a plurality of lamp fixing units (not shown) for fixing the lamps, and a lamp support (not shown) in which the plurality of lamp fixing units are received. The plurality of lamps mainly employ cold cathode fluorescent lamps ("CCFLs"), and each of the lamps includes a glass tube, inert gas contained in the glass tube, and cathode and anode electrodes respectively installed at both ends of the glass tube. While it has been described in this embodiment that a bar-type lamp is used as the lamp, the present invention is not limited thereto. That is, a variety of lamps may be used. Furthermore, other types of lamp units 400 and backlight assemblies for the LCD would be within the scope of these embodiments.

The plurality of optical sheets 700 includes a plurality of prism sheets and a protective sheet 710, and a diffusion plate 720. The diffusion plate 720 allows light incident form the plurality of lamps in the lamp unit 400 to be directed toward the front surface of the LCD panel 100 and then to be diffused and uniformly distributed in a wide range such that the light can be irradiated onto the LCD panel 100. The plurality of prism sheets serves to change inclined light among the incident light to be emitted in a vertical direction. The protective sheet serves to protect the plurality of prism sheets. The number and function of the optical sheets 700 may be changed in various ways.

The mold frame 800 includes a receiving space in which the LCD panel 100, the lamp unit 400 and the plurality of optical sheets 700 are inserted. In the illustrated embodiment, the mold frame 800 is formed into a rectangular frame with an open central region corresponding to a display region of the LCD panel 100.

The lower container 900 is formed into a rectangular box with an open upper face and formed with a receiving space of a predetermined depth such that the lamp unit 400 can be disposed therein. That is, the lower container 900 includes a bottom surface and sidewalls extending vertically from edges of the bottom surface.

Predetermined holes are formed in the sidewalls of the mold frame 800, and hooks corresponding to the holes of the mold frame 800 are formed in the sidewalls of the lower container 900. The hooks are coupled to the holes such that the mold frame 800 and the lower container 900 are coupled with each other. In an alternative embodiment, the locations of the hooks and the holes may be reversed. In addition, a coupling hole, as will be further described below, is formed in one sidewall of the mold frame 800 such that the coupling member 255 formed on the data-side PCB 250 can penetrate therethrough. A coupling hole, as will also be further described below, is also formed in one sidewall of the lower container 900 such that the coupling member 255 formed on the data-side PCB 250 can penetrate therethrough.

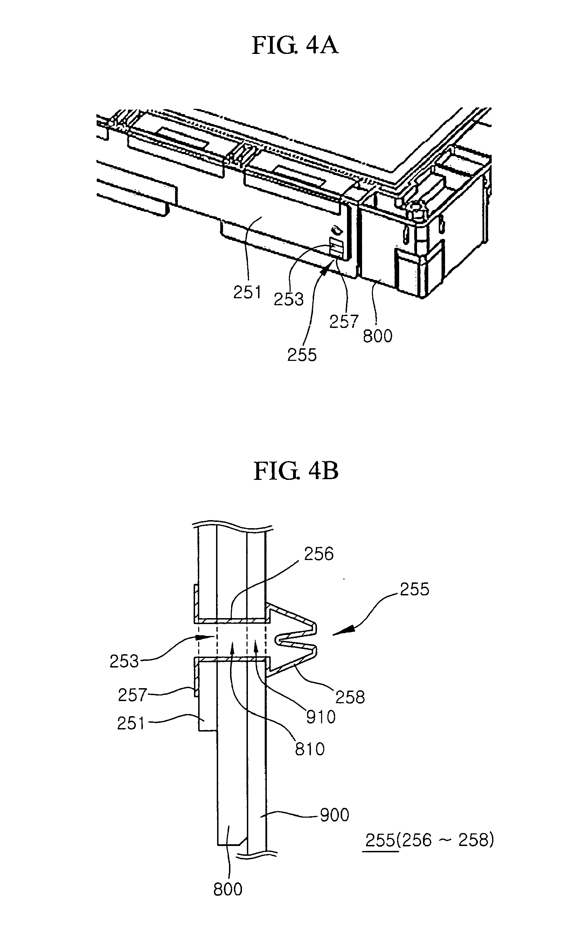

Fig. 3 is a schematic perspective view of an exemplary PCB according to a first exemplary embodiment of the present invention, and Figs. 4A and 4B are perspective and sectional views showing a state where the exemplary PCB according to the first exemplary embodiment of the present invention is coupled to the exemplary mold frame and the exemplary lower container.

Referring to Figs. 3, 4A and 4B, the PCB 250 includes a base plate 251 and a coupling member 255. The base plate 251 is a region on which a predetermined circuit pattern is printed to mount a plurality of circuit parts for driving the LCD panel 100, such as a timing controller for generating an electric signal to control a gate driver IC and a source driver IC and controlling a digital data signal input from a computer or the like, a DC-DC converter circuit for generating different kinds of voltages, and a gamma standard voltage generator for outputting a gray scale voltage of the source driver IC.

The coupling member 255 is formed on a corner of the base plate 251 in the form of a protrusion. In addition, the coupling member 255 is made of a conductive material with excellent electric conductivity, such as, but not limited to, copper or copper alloy such as bronze or phosphoric bronze. In the illustrated embodiment, two coupling members 255 are formed at two corners of the base plate 251. However, the number and positions of the coupling members 255 are not limited thereto and may be changed in various ways.

The coupling member 255 includes a body portion 256, a fixing portion 257 formed at one end of the body portion 256 and fixed to the base plate 251, and a head portion 258 formed at the other end of the body portion 256 and coupled to the lower container 900 of the LCD.

The fixing portion 257 of the coupling member 255 is formed to extend in a direction substantially perpendicular to the body portion 256, and a coupling hole 253 corresponding to the body portion 256 of the coupling member 255 is formed in the base plate 251. The fixing portion 257 penetrates through the coupling hole 253 of the base plate 251 and is arranged on the other surface of the base plate 251 opposite to a surface on which the head portion 258 of the coupling member 255 is positioned, and the other surface of the base plate 251 and a contact surface of the fixing portion 257 are soldered with each other. In other words, the base plate 251 includes a first surface facing the mold frame 800 and a second opposite surface to which the fixing portion 257 is secured.

The head portion 258 penetrates through a coupling hole 810 formed in the mold frame 800 and a coupling hole 910 formed in the lower container 900 and is also coupled with the lower container 900. One end, a first end, of the head portion 258 has a width greater than a width of the body portion 256, and the other end, a second end, of the head portion 258 tapers. For example, the head portion 258 generally has an arrowhead or cone shape. In other words, the head portion 258 tapers from a wide portion beginning at the first end of the head portion 258 to a narrower portion ending at the second end of the head portion 258. In addition, a groove may be formed in an internal central region of the head portion 258 such that the head portion 258 can be separated into two parts and spaced apart from each other by a predetermined distance to exhibit predetermined elasticity. Thus, when the head portion 258 penetrates through the coupling holes 810 and 910 respectively formed in the mold frame 800 and the lower container 900, the head portion 258 is inserted in a state where the spaced interval is decreased, i.e. both parts of the head portion 258 are brought into contact with each other. Thus, the head portion 258 of the coupling member 255 can be easily inserted into the coupling holes 810, 910. After the head portion 258 has been completely penetrated through the coupling holes 810 and 910 respectively formed in the mold frame 800 and the lower container 900, the head portion 258 is restored into its original shape such that one end of the head portion 258 can be caught to the coupling hole 910 of the lower container 900 to allow the coupling member 255 to be firmly contacted and coupled with the lower container 900. In the original, uncompressed shape of the head portion 258, the first end of the head portion 258 has a greater width than a width of the coupling hole 910 such that the coupling member 255 cannot be inadvertently disengaged from the lower container 900. Also, the first end of the head portion 258 may lie substantially flush with a wall, such as the sidewall, of the lower container 900.

At this time, the body portion 256, the fixing portion 257, and the head portion 258 of the coupling member 255 are preferably integrally formed with one another. In addition, the sizes of the coupling holes 810 and 910 respectively formed in the mold frame 800 and the lower container 900 are preferably formed in correspondence with the width of the body portion 256 of the coupling member 255.

In one exemplary embodiment, the coupling member 255 is formed into a hollow shape using a plate member through press processing. However, the present invention is not limited thereto. For example, the coupling member 255 may be formed into a solid shape while its shape is maintained as a whole.

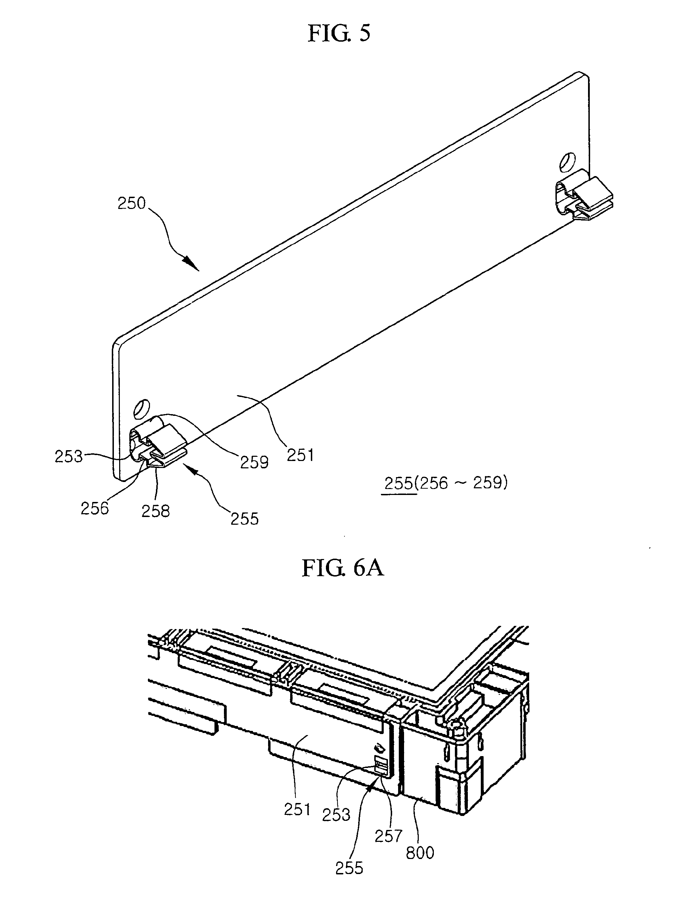

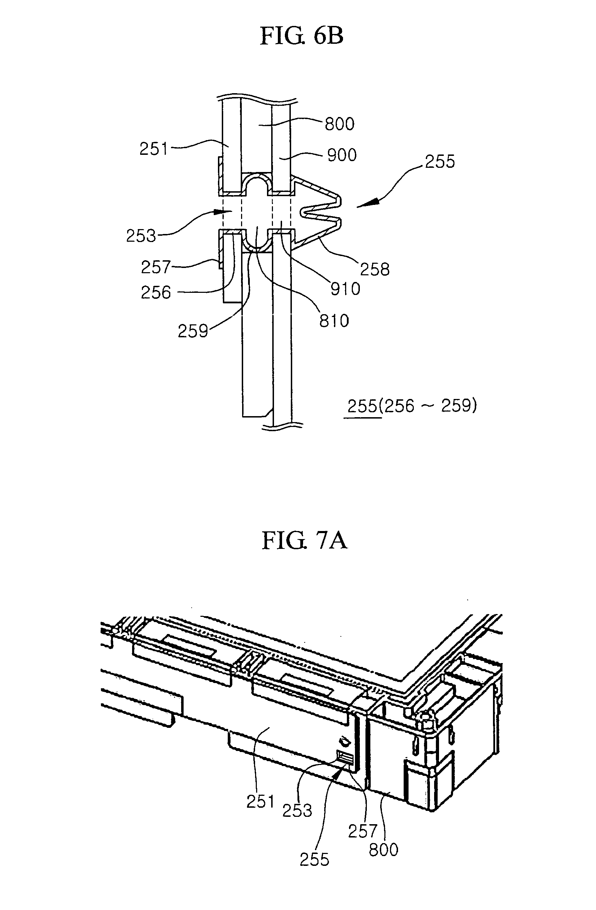

Fig. 5 is a schematic perspective view of an exemplary PCB according to a second exemplary embodiment of the present invention, and Figs. 6A and 6B are perspective and sectional views illustrating a state where the exemplary PCB according to the second exemplary embodiment of the present invention is coupled to the exemplary mold frame and the exemplary lower container.

The PCB according to the second exemplary embodiment of the present invention shown in Figs. 5, 6A, and 6B is substantially similar to the PCB of the first exemplary embodiment, except that an additional protrusion is formed on the body portion of the coupling member. Hereinafter, the different configuration will be described.

Referring to Figs. 5, 6A, and 6B, the PCB 250 includes the base plate 251 and the coupling member 255. The base plate 251 is a region on which a predetermined circuit pattern is printed to mount a plurality of circuit parts for driving the LCD panel 100.

The coupling member 255 is formed on a corner of the base plate 251 in the form of a protrusion. In addition, the coupling member 255 is made of a conductive material with excellent electric conductivity, such as, but not limited to, copper or copper alloy such as bronze or phosphoric bronze. In the illustrated embodiment, two coupling members 255 are formed at two corners of the base plate 251. However, the number and positions of the coupling members 255 are not limited thereto but may be changed in various ways.

The coupling member 255 includes a body portion 256, a fixing portion 257 formed at one end, a first end, of the body portion 256 and fixed to the base plate 251, a head portion 258 formed at the other end, a second end, of the body portion 256 and coupled to the lower container 900 of the LCD, and a protrusion 259 formed to protrude outward from the body portion 256.

The fixing portion 257 of the coupling member 255 is formed to extend in a direction perpendicular to the body portion 256, and a coupling hole 253 corresponding to the body portion 256 of the coupling member 255 is formed in the base plate 251. The fixing portion 257 penetrates through the coupling hole 253 of the base plate 251 and is arranged on the other surface of the base plate 251 opposite to a surface on which the head portion 258 of the coupling member 255 is positioned, and the other surface of the base plate 251 and a contact surface of the fixing unit 257 are soldered with each other. In other words, the base plate 251 includes a first surface facing the mold frame 800 and a second opposite surface to which the fixing portion 257 is secured.

The head portion 258 penetrates through a coupling hole 810 formed in the mold frame 800 and a coupling hole 910 formed in the lower container 900 and is also coupled with the lower container 900. In this exemplary embodiment, the coupling hole 810 may be larger than the coupling hole 910 to accommodate the protrusion 259. One end, a first end, of the head portion 258 has a width greater than the body portion 256, and the other end, a second end, of the head portion 258 tapers. For example, the head portion 258 generally has an arrowhead or cone shape. In addition, a groove may be formed in an internal central region of the head portion 258 such that the head portion 258 can be separated into two parts and spaced apart from each other by a predetermined distance to exhibit predetermined elasticity. Thus, the head portion 258 can be easily inserted into the coupling holes 810, 910. After the insertion of the head portion 258 has been completed, the coupling member 255 can be firmly coupled with the lower container 900. In the original, uncompressed shape of the head portion 258, the first end of the head portion 258 has a greater width than a width of the coupling hole 910 such that the coupling member 255 cannot be inadvertently disengaged from the lower container 900. Also, the first end of the head portion 258 may lie substantially flush with a wall, such as the sidewall, of the lower container 900.

The protrusion 259 is formed on a middle region of the body portion 256 to protrude outward from the body portion 256, i.e. in an extending direction of the fixing portion 257. In this embodiment, the protrusion 259 is formed into a hemispherical shape, but its shape may be changed in various ways. The protrusion 259 may provide a function of allowing the body portion 256 of the coupling member 255 to be brought into close contact with and thus to be further firmly coupled with the lower container 900. In other words, in addition to the first end of the head portion 258 being in close contact with a first surface of the lower container 900, the protrusion 259 is also in close contact with a second opposite surface of the lower container 900, thus ensuring the close contact of the coupling member 255 with the lower container 900. Furthermore, in a case where the mold frame 800 is not used, the protrusion 259 may perform a function of allowing the PCB 250 to be spaced apart from the lower container 900 by a predetermined distance. In addition, since an area where the coupling member 255 is brought into contact with the lower container 900 is increased, more secure grounding can be obtained and thus the shielding against electromagnetic interference can also be further improved.

The body portion 256, the protrusion 259, the fixing portion 257, and the head portion 258 of the coupling member 255 are preferably integrally formed with one another. In addition, it is preferred that the size of the coupling hole 810 formed in the sidewall of the mold frame 800 be greater than the total width of the body portion 256 and the protrusion 259 and the size of the coupling hole 910 formed in the sidewall of the lower container is equal to, or substantially equal to, the width of the body portion 256 of the coupling member 255 at a location where the protrusion 259 does not protrude.

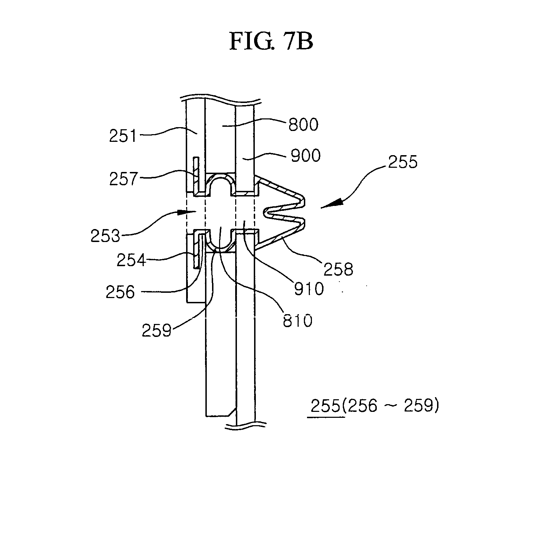

Figs. 7A and 7B are perspective and sectional views illustrating a state where an exemplary PCB according to a third exemplary embodiment of the present invention is coupled to the exemplary mold frame and the exemplary lower container.

The PCB according to the third exemplary embodiment of the present invention shown in Figs. 7A and 7B is substantially similar to that of the previous embodiments, except that the coupling member is not soldered but coupled with the mold frame and the lower container. Hereinafter, the different configuration will be described.

Referring to Figs. 7A and 7B, the PCB 250 includes the base plate 251 and the coupling member 255. The base plate 251 is a region on which a predetermined circuit pattern is printed to mount a plurality of circuit parts for driving the LCD panel 100. The coupling member 255 is formed on a corner of the base plate 251 in the form of a protrusion. In the illustrated embodiment, two coupling members 255 are formed in opposite corners of the base plate 251. However, alternate quantities of coupling members 255 In addition, the coupling member 255 is made of a conductive material with excellent electric conductivity, such as, but not limited to, copper or copper alloy such as bronze or phosphoric bronze.

The coupling member 255 includes a body portion 256, a fixing portion 257 formed at one end, a first end, of the body portion 256 and fixed to the base plate 251, a head portion 258 formed at the other end, a second end, of the body portion 256 and coupled to the lower container 900 of the LCD, and a protrusion 259 formed to protrude outward from the body portion 256.

The fixing portion 257 of the coupling member 255 is formed to extend in a direction perpendicular to the body portion 256, and a coupling hole 253 corresponding to the body portion 256 of the coupling member 255 is formed in the base plate 251. A predetermined groove 254 is formed in an inner sidewall of the coupling hole 253, and the fixing portion 257 of the coupling member 255 is inserted and fixed in the groove 254. At this time, the groove 254 is preferably formed in correspondence with the shape and thickness of the fixing portion 257. The base plate 251 includes a first surface facing the mold frame 800 and a second opposite surface, and the groove 254 may be formed between the first and second surfaces of the base plate 251, and may extend parallel to the first and second surfaces of the base plate 251. Since the predetermined groove 254 is formed in the inner sidewall of the coupling hole 253 of the base plate 251 and the fixing portion 257 is then inserted and fixed in the groove 254, the coupling member 255 can be fixed to the base plate 251 without an additional soldering process.

The head portion 258 penetrates through the coupling hole 810 formed in the mold frame 800 and the coupling hole 910 formed in the lower container 900 and is also coupled with the lower container 900. One end, a first end, of the head portion 258 has a width greater than the body portion 256, and the other end, a second end, of the head portion 258 tapers. The protrusion 259 is formed on a middle region of the body portion 256 to protrude outward from the body portion 256, i.e. in an extending direction of the fixing portion 257. The body portion 256, the fixing portion 257, and the head portion 258 of the coupling member 255 are preferably integrally formed with one another. In addition, it is preferred that the size of the coupling hole 810 formed in the sidewall of the mold frame be greater than the total width of the body portion 256 and the protrusion 259 and the size of the coupling hole 910 formed in the sidewall of the lower container 900 is equal to, or substantially equal to, the width of the body portion 256 of the coupling member 255.

In another exemplary embodiment, the groove 254 may also be formed in the base plate 251 to accommodate the coupling member 255 of the first exemplary embodiment as shown in Figs. 3, 4A, and 4B. In other words, the groove 254 may be used in an embodiment of the coupling member 255 not having the protrusion 259.

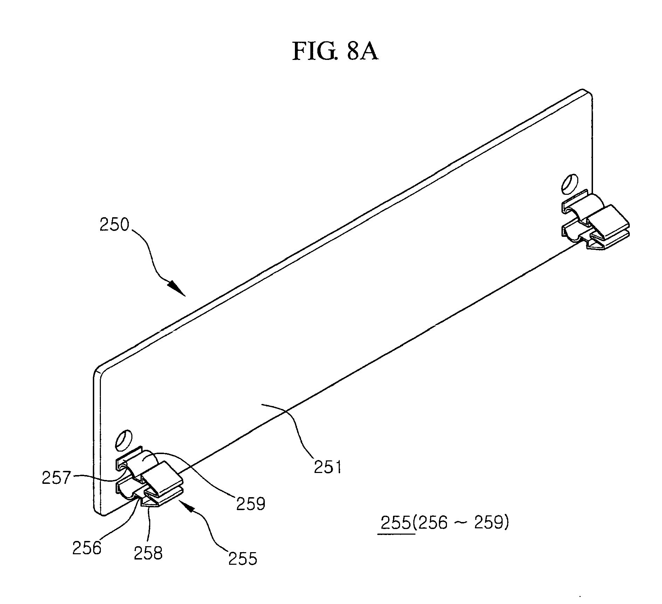

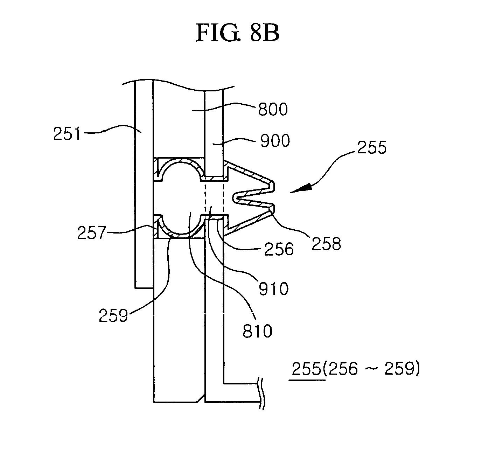

Figs. 8A and 8B are a schematic perspective view of an exemplary PCB according to a fourth exemplary embodiment of the present invention and a sectional view illustrating a state where the exemplary PCB is coupled with the exemplary mold frame and the exemplary lower container, respectively.

The PCB according to the exemplary fourth embodiment of the present invention shown in Figs. 8A and 8B is substantially similar to the PCB of the previous exemplary embodiments, except that the fixing portion of the coupling member is soldered to one surface of the base plate without using a coupling hole formed in the base plate of the PCB. Hereinafter, the different configuration will be described.

Referring to Figs. 8A and 8B, the PCB 250 includes the base plate 251 and the coupling member 255. The base plate 251 is a region on which a predetermined circuit pattern is printed to mount a plurality of circuit parts for driving the LCD panel 100. In the illustrated embodiment, two coupling members 255 are formed at two corners of the base plate 251. However, the number and positions of the coupling members 255 are not limited thereto and may be changed in various ways.

The coupling member 255 includes a body portion 256, a fixing portion 257 formed at one end, a first end, of the body portion 256 and fixed to the base plate 251, a head portion 258 formed at the other end, a second end, of the body portion 256 and coupled to the lower container 900 of the LCD, and a protrusion 259 formed to protrude outward from the body portion 256.

The fixing portion 257 of the coupling member 255 is formed to extend in a direction perpendicular to the body portion 256. The fixing portion 257 is arranged on a surface of the base plate 251, i.e. a surface on which the head portion 258 of the coupling member 255 is arranged. In other words, the base plate 251 includes a first surface facing the mold frame 800 and a second opposite surface, and the fixing portion 257 is arranged on the first surface of the base plate 251. Further, one surface of the base plate 251 and a contact surface of the fixing portion 257 are fixed to each other by means of solder.

The head portion 258 penetrates through a coupling hole 810 formed in the mold frame 800 and a coupling hole 910 formed in the lower container 900 and is also coupled with the lower container 900. The coupling hole 810 may be larger than the coupling hole 910 to accommodate the protrusion 259. One end, a first end, of the head portion 258 has a width greater than the body portion 256, and the other end, a second end, of the head portion 258 tapers. For example, the head portion 258 generally has an arrowhead or cone shape. In addition, a groove is formed in an internal central region of the head portion 258 such that the head portion 258 can be separated into two parts and spaced apart from each other by a predetermined distance to exhibit predetermined elasticity. Thus, the head portion 258 can be easily inserted into the coupling holes 810, 910. After the insertion of the head portion 258 has been completed, the coupling member 255 can be firmly coupled with the lower container 900. In the original, uncompressed shape of the head portion 258, the first end of the head portion 258 has a greater width than a width of the coupling hole 910 such that the coupling member 255 cannot be inadvertently disengaged from the lower container 900. Also, the first end of the head portion 258 may lie substantially flush with a wall, such as the sidewall, of the lower container 900.

The protrusion 259 is formed on a middle region of the body portion 256 to protrude outward from the body portion 256, i.e. in an extending direction of the fixing portion 257.

In another exemplary embodiment, the fixing portion 257 of the coupling member 255 of the first exemplary embodiment shown in Figs. 3, 4A, and 4B may be affixed to the surface of the base plate 251 facing the mold frame 800 as described with respect to the fourth exemplary embodiment. In other words, attachment of the fixing portion 257 to the first surface of the base plate 251 as shown in Figs. 8A and 8B may also be used in an embodiment of the coupling member 255 not having the protrusion 259.

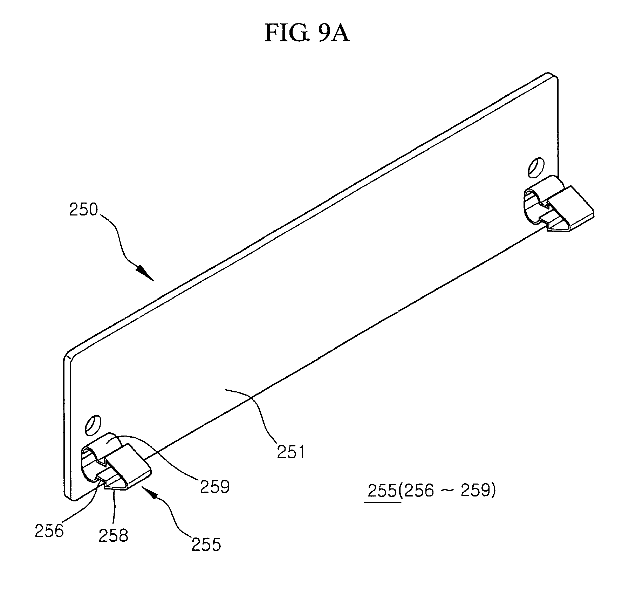

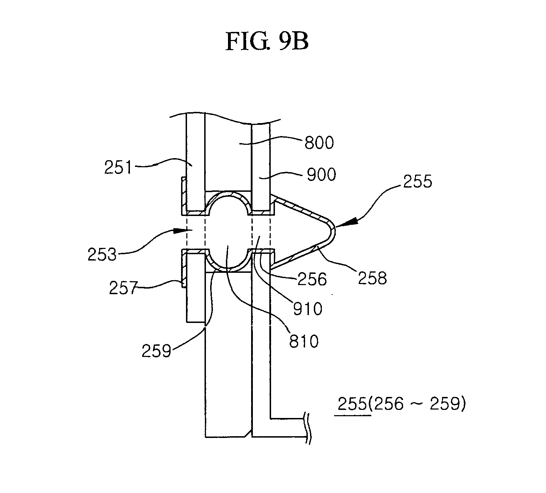

Figs. 9A and 9B are a schematic perspective view of an exemplary PCB according to a fifth exemplary embodiment of the present invention and a sectional view illustrating a state where the exemplary PCB is coupled with the exemplary mold frame and the exemplary lower container, respectively.

Referring to Figs. 9A and 9B, the PCB 250 includes the base plate 251 and the coupling member 255. The coupling member 255 includes a body portion 256, a fixing portion 257 formed at one end, a first end, of the body portion 256 and fixed to the base plate 251, a head portion 258 formed at the other end, a second end, of the body portion 256 and coupled to the lower container 900 of the LCD, and a protrusion 259 formed to protrude outward from the body portion 256.

The head portion 258 penetrates through a coupling hole 810 formed in the mold frame 800 and a coupling hole 910 formed in the lower container 900 and is also coupled with the lower container 900. The coupling hole 810 may be larger than the coupling hole 910 so as to accommodate the protrusion 259. One end, a first end, of the head portion 258 has a width greater than the body portion 256, and the other end, a second end, of the head portion 258 tapers. For example, the head portion 258 generally has an arrowhead or cone shape. At this time, an internal central region of the head portion 258 is not formed to be spaced apart by a predetermined distance. Nevertheless, since the body portion 256 and the head portion 258 themselves have predetermined elasticity, the head portion 258 can be easily inserted into the coupling holes 810, 910. After the insertion of the head portion 258 has been completed, the coupling member 255 can be firmly coupled with the lower container 900.

In alternative embodiments, the fixing portion 257 may be affixed to the base plate 251 as in the other exemplary embodiments described herein.

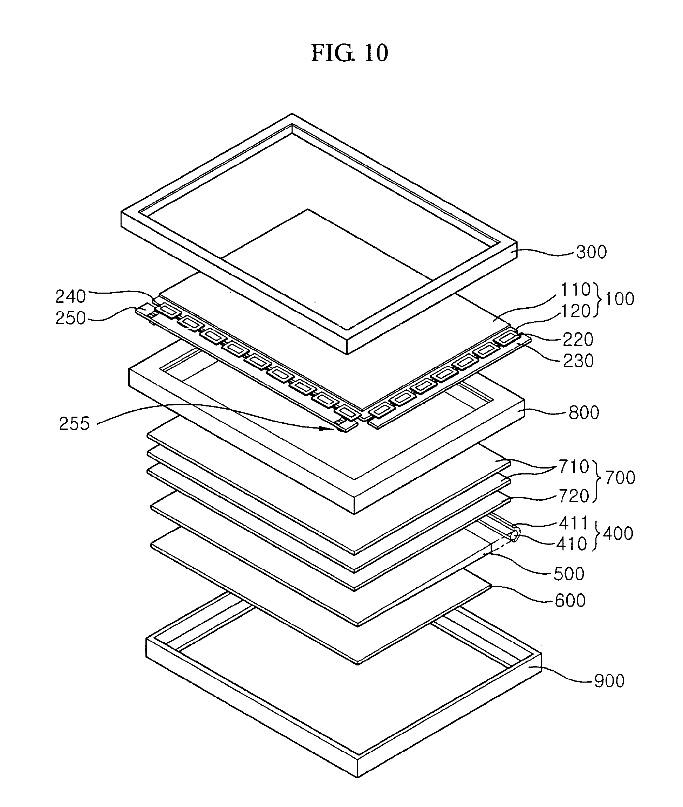

Fig. 10 is an exploded perspective view showing another exemplary LCD having an exemplary PCB according to exemplary embodiments of the present invention.

Referring to Fig. 10, the LCD is equipped with an edge-type backlight unit that is generally used in a small-sized or medium-sized LCD such as a laptop or desktop computer. The LCD includes an upper container 300, an LCD panel 100, driving circuit units 220 to 250, a plurality of optical sheets 700, a lamp unit 400, a light guide plate 500, a reflection plate 600, a mold frame 800, and a lower container 900.

As described above, the driving circuit includes a gate-side PCB 230, a data-side PCB 250, a gate-side flexible PCB 220, and a data-side flexible PCB 240. Coupling members 255, each formed of a conductive material and having a protruding shape, are formed on both end corners of the data-side PCB 250. Each coupling member 255 is coupled to a coupling hole (not shown) formed in the mold frame 800 and a coupling hole (not shown) formed in the lower container 900. Thus, the data-side PCB 250 is fixed to one sidewall of the mold frame 800 and simultaneously forms a ground structure with the lower container 900. As a result, contrary to the prior art, the PCB 250 and the mold frame 800 can be easily coupled with each other. Further, the PCB 250 is coupled to the lower container 900 by means of the coupling member 255 to form a ground structure, so that the electromagnetic interference can be shielded without any additional parts. In alternative embodiments, the coupling members 255 may be used on the gate side PCB 230, or on both the data side PCB 250 and the gate side PCB 230. The coupling members 255 may include any combination of features described with respect to the above-described embodiments.

Although exemplary embodiments have been illustrated with respect to the LCD type of flat panel displays, the PCB for use in a flat panel display according to exemplary embodiments of the present invention is not limited to the aforementioned LCD. That is, the present invention may be applied to flat panel displays such as an organic light emitting display ("OLED") using a principle (referred to as "electroluminescence") in which when a light emitting material made of an organic material or conjugated polymer with a semiconductor property is interposed between two electrodes and a voltage is then applied thereto, light is generated from the organic material or polymer while a current flows into the light emitting material; a plasma display panel ("PDP") in which a plurality of small cells are arranged between two substrates and gas (neon or argon) discharge is generated between electrodes (positive and negative) above and below the substrates such that the cells cause self luminescence by means of ultraviolet rays generated due to the gas discharge, thereby reproducing color images; or the like.

In addition, although the exemplary embodiments have been illustrated with respect to the data-side PCB, the present invention is not limited thereto. That is, the present invention may be applied to a gate-side PCB or both gate-side and data-side PCBs.

According to exemplary embodiments of the present invention described above, a PCB and a mold frame can be easily coupled with each other. Further, a coupling member made of a conductive material is used for coupling the PCB and the lower container with each other such that a ground structure can be formed. Therefore, the electromagnetic interference can be shielded without using any additional parts.

A method of coupling a PCB within a flat display is thus made possible, where the method includes affixing a conductive coupling member to a base plate of the PCB, passing the coupling member through a coupling hole formed in a mold frame of the flat panel display, and passing the coupling member through a coupling hole formed in a container of the flat panel display. The method may further include forming a ground structure between the PCB and the container by contacting the coupling member to the container.

The aforementioned descriptions are merely for illustration of a PCB for a flat panel display according to the present invention and a flat panel display using the PCB. Accordingly, the present invention is not limited to the aforementioned embodiments and it will be readily understood by those skilled in the art that various modifications and changes can be made thereto within the technical spirit and scope of the present invention. It is also apparent that the modifications and changes fall within the scope of the present invention defined by the appended claims.

## Claims

1. A printed circuit board for a flat panel display, comprising:
a base plate with a circuit pattern printed thereon to mount a plurality of circuit parts driving the flat panel display; and
a coupling member formed on the base plate, the coupling member formed in a form of a protrusion and made of a conductive material.

2. The printed circuit board as claimed in claim 1, wherein the coupling member includes:
a body portion;
a fixing portion formed at a first end of the body portion and fixed to the base plate; and
a head portion formed at a second end of the body portion and coupled to a container of the flat panel display.

3. The printed circuit board as claimed in claim 2, wherein the fixing portion extends in a direction perpendicular to the body portion.

4. The printed circuit board as claimed in claim 3, wherein the fixing portion is arranged on one surface of the base plate and fixed to the base plate by solder.

5. The printed circuit board as claimed in claim 3, wherein a coupling hole is formed in the base plate, the body portion is positioned in the coupling hole, and the fixing portion of the coupling member is arranged on a surface of the base plate and fixed to the base plate by solder.

6. The printed circuit board as claimed in claim 3, wherein a coupling hole is formed in the base plate, a groove is formed in an inner sidewall of the coupling hole, and the fixing portion of the coupling member is inserted and fixed in the groove.

7. The printed circuit board as claimed in claim 2, wherein the head portion includes a first end having a width greater than a width of the body portion, and a second end tapering from the first end.

8. The printed circuit board as claimed in claim 7, wherein a groove is formed in a central region of the head portion such that the head portion is separated into two parts spaced apart from each other by a distance.

9. The printed circuit board as claimed in claim 2, wherein the coupling member further includes a catching protrusion protruding outwardly from the body portion.

10. The printed circuit board as claimed in claim 2, wherein the body portion, the fixing portion, and the head portion of the coupling member are integrally formed with one another.

11. The printed circuit board as claimed in claim 1, wherein at least two coupling members are formed at corner regions of the base plate.

12. The printed circuit board as claimed in claim 1, wherein the coupling member is made of copper or alloy thereof.

13. A flat panel display, comprising:
a flat display panel displaying an image thereon;
a printed circuit board mounted with a plurality of circuit parts driving the flat display panel;
a frame formed with a receiving space therein; and
a container coupled with the frame,
wherein the printed circuit board includes a base plate with a circuit pattern printed thereon to mount the plurality of circuit parts thereon, and a coupling member formed on the base plate, the coupling member formed in a form of a protrusion and made of a conductive material; and the coupling member of the printed circuit board is coupled to the container.

14. The flat panel display as claimed in claim 13, wherein a coupling hole is formed in the frame and a coupling hole is formed in the container, the coupling member penetrating through the coupling holes.

15. The flat panel display as claimed in claim 13, wherein the coupling member includes:
a body portion;
a fixing portion formed at a first end of the body portion and fixed to the base plate; and
a head portion formed at a second end of the body portion and coupled to a container of the flat panel display.

16. The flat panel display as claimed in claim 15, wherein the fixing portion extends in a direction perpendicular to the body portion.

17. The flat panel display as claimed in claim 16, wherein the fixing portion is arranged on one surface of the base plate and fixed to the base plate by solder.

18. The flat panel display as claimed in claim 16, wherein a coupling hole is formed in the base plate, the body portion is positioned in the coupling hole, and the fixing portion of the coupling member is arranged on a surface of the base plate and fixed to the base plate by solder.

19. The flat panel display as claimed in claim 16, wherein a coupling hole is formed in the base plate, a groove is formed in an inner sidewall of the coupling hole, and the fixing portion of the coupling member is inserted and fixed in the groove.

20. The flat panel display as claimed in claim 15, wherein the head portion includes a first end having a width greater than a width of the body portion and a second end tapering from the first end.

21. The flat panel display as claimed in claim 20, wherein a groove is formed in a central region of the head portion such that the head portion is separated into two parts spaced apart from each other by a distance.

22. The flat panel display as claimed in claim 20, wherein the first end of the head portion lies substantially flush with a sidewall of the container.

23. The flat panel display as claimed in claim 15, wherein the coupling member further includes a catching protrusion protruding outwardly from the body portion.

24. The flat panel display as claimed in claim 23, wherein the catching protrusion contacts a surface of the container facing the frame.

25. The flat panel display as claimed in claim 15, wherein the body portion, the fixing portion and the head portion of the coupling member are integrally formed with one another.

26. The flat panel display as claimed in claim 13, wherein the coupling member is made of copper or alloy thereof.

27. The flat panel display as claimed in claim 13, wherein the printed circuit board is arranged on a sidewall of the frame.

28. The flat panel display as claimed in claim 13, wherein the flat display panel is a liquid crystal display panel.

29. The flat panel display as claimed in claim 13 wherein coupling the printed circuit board and the container with the coupling member forms a ground structure.

30. A method of coupling a printed circuit board within a flat display, the method comprising:
affixing a conductive coupling member to a base plate of the printed circuit board;
passing the coupling member through a coupling hole formed in a frame of the flat panel display; and,
passing the coupling member through a coupling hole formed in a container of the flat panel display.

31. The method as claimed in claim 30 further comprising forming a ground structure between the printed circuit board and the container by contacting the coupling member to the container.
